# FASCICULE DE BREVET EUROPEEN

(11) **EP 0 559 545 B1**
(45) Date de publication et mention de la délivrance du brevet: **12.06.1996**
(21) Numéro de dépôt: 93400525.7
(22) Date de dépôt: 02.03.1993
(51) Int. Cl.: H03F 3/50, H03F 1/32

(54) **Etage de sortie push-pull pour amplificateur en circuit intégré**
Gegentaktausgangsstufe für integrierten Verstärker
Push-pull output stage for integrated amplifier

(30) Priorité: 03.03.1992 FR 9202493
(43) Date de publication de la demande: 08.09.1993
(73) Titulaire: THOMSON-CSF SEMICONDUCTEURS SPECIFIQUES, 75008 Paris (FR)
(72) Inventeur: Debroux, Jean-François, Thomson-CSF, F-92402 Courbevoie Cédex (FR)
(74) Mandataire: Guérin, Michel

(56) Documents cités:
- US-A- 3 887 879
- US-A- 3 974 456
- US-A- 4 587 491

## Description

L'invention concerne un étage de sortie d'amplificateur, destiné à être réalisé en circuit-intégré.

Pour fournir des courants importants à une charge, que celle-ci soit résistive ou capacitive ou mixte, sans travailler avec un courant de repos important, on utilise le plus souvent des étages de sortie de type push-pull.

Un étage push-pull comprend deux transistors principaux placés en série entre une borne d'alimentation positive et une borne d'alimentation négative. L'un des transistors fournit le courant pendant les alternances positives, l'autre pendant les alternances négatives.

Le point de jonction des transistors constitue la sortie de l'étage. La charge est reliée entre cette sortie et une borne de référence qui est à un potentiel intermédiaire entre celui des deux bornes d'alimentation.

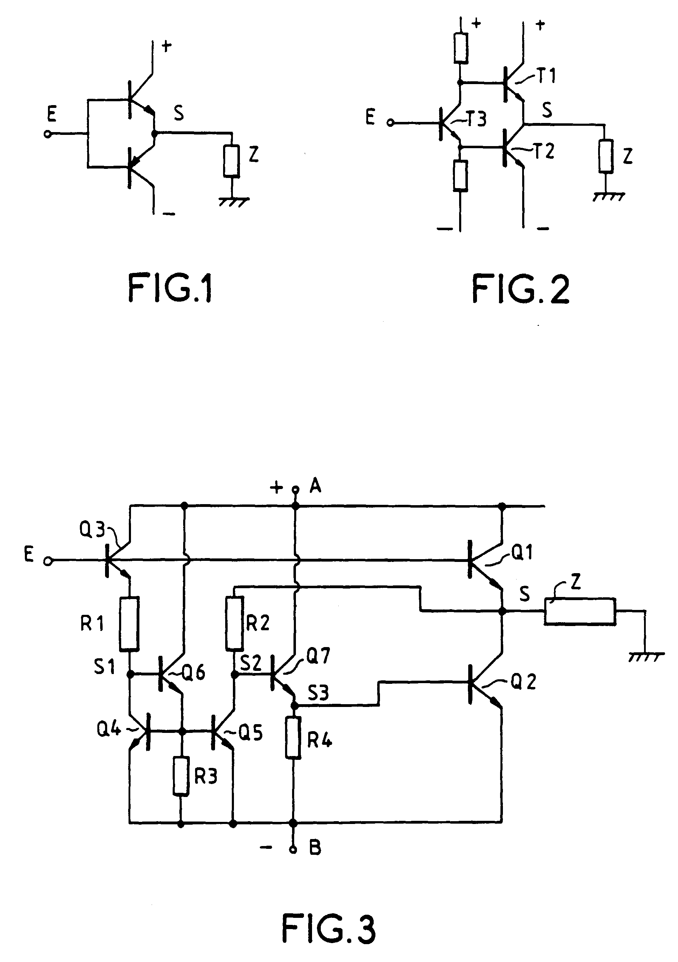

Dans l'étage push-pull le plus classique (figure 1), le transistor T1 relié à la borne d'alimentation positive est de type NPN; l'autre, T2, est de type PNP. Les émetteurs sont reliés à la sortie S et les bases sont reliées à l'entrée E. Le courant de repos, c'est-à-dire le courant traversant les transistors lorsque la tension de sortie est nulle, peut être faible ou même nul.

Mais dans les techniques d'intégration monolithique on préfèrerait ne pas utiliser de transistor PNP. Ils sont encombrants et peu rapides. Et on préfère aussi ne pas utiliser d'autres technologies mélangeant par exemple des transistors bipolaires et des transistors à effet de champ : d'une part cela complique considérablement la technologie, et d'autre part les performances de l'étage seraient affectées défavorablement en ce qui concerne la vitesse car les transistors à effet de champ présentent des capacités qui ralentissent beaucoup les signaux électriques.

On a donc déjà proposé de réaliser des étages de type push-pull n'utilisant que des transistors NPN. Un exemple en est donné à la figure 2. Cet étage comporte deux transistors de sortie T1 et T2 capables de fournir des courants importants à une charge Z, ces deux transistors étant en série entre les bornes d'alimentation positive et négative, leur point de jonction constituant la sortie S à laquelle est reliée la charge Z. L'un des transistors fournit le courant sortant vers la charge (alternances positives), l'autre le courant rentrant en provenance de la charge (alternances négatives). Un troisième transistor T3 commande les deux premiers : les bases des deux premiers transistors sont reliées respectivement au collecteur et à l'émetteur du troisième. L'entrée E de l'étage est la base du troisième transistor; ce dernier est polarisé avec une résistance d'émetteur et une résistance de collecteur.

Cet étage de sortie est mieux adapté à l'intégration monolithique car il ne comporte que des transistors NPN; une seule technologie (bipolaire NPN) est nécessaire. Il bénéficie par ailleurs de la rapidité de la technologie bipolaire NPN. Mais il présente une linéarité médiocre. Il ne peut guère être utilisé que comme amplificateur auxiliaire dans un système bouclé (où le bouclage assure la linéarité); mais il ne peut alors être utilisé que pour des fréquences assez basses et on perd donc l'avantage que l'on pouvait tirer de l'utilisation d'une technologie entièrement NPN.

On a aussi proposé, dans le brevet US-A- 4 587 491, une solution mixte avec deux transistors NPN de sortie mais un mélange de transistors PNP et NPN en amont des transistors de sortie. La présence de ces transistors PNP nuit à la rapidité de l'étage et à la facilité de réalisation technologique.

L'invention a pour but d'éviter les inconvénients des circuits de la technique antérieure, et plus précisément
- éviter d'utiliser des transistors autres que NPN dans l'étage push-pull,
- obtenir une rapidité de fonctionnement supérieure à celle des étages push-pull connus, que ces derniers utilisent uniquement des transistors NPN ou qu'ils mélangent les types de transistors .

Pour obtenir ces résultats, la présente invention propose un étage push-pull qui comporte en résumé les dispositions suivantes : il y a deux transistors principaux NPN en série entre les deux bornes d'alimentation de l'étage; la sortie est le point commun entre l'émetteur du premier et le collecteur du deuxième; un troisième transistor NPN a sa base et son collecteur reliés respectivement à la base et au collecteur du premier; deux branches de circulation de courant sont formées, l'une connectée à l'émetteur du troisième transistor pour établir un courant dépendant du potentiel de cet émetteur et l'autre connectée à l'émetteur du premier transistor pour établir également un courant dépendant du potentiel de cet émetteur, les deux branches étant par ailleurs montées en miroir de courant de manière que la deuxième branche tende à recopier le courant dans la première; le miroir de courant comporte une sortie en courant représentant l'écart entre le courant établi dans la deuxième branche et le courant recopié de la première; cette sortie en courant est utilisée pour commander la conduction du deuxième transistor. L'étage est entièrement réalisé à partir de transistors NPN.

Si on détaille plus précisément la construction, l'étage de sortie de type push-pull selon l'invention comporte, en série entre une borne d'alimentation positive et une borne d'alimentation négative, un premier transistor de sortie NPN pour fournir un courant à une charge et un deuxième transistor de sortie NPN pour recevoir un courant issu de la charge, l'émetteur du premier transistor et le collecteur du deuxième étant reliés à un même noeud constituant la sortie de l'étage, l'étage comportant encore un troisième transistor NPN ayant sa base reliée à la base du premier transistor et reliée à une entrée de l'étage, une première branche de circulation de courant connectée entre l'émetteur du troisième transistor et la borne d'alimentation négative pour établir un courant dépendant du potentiel sur l'émetteur du troisième transistor, et une deuxième branche de circulation de courant reliée entre l'émetteur du premier transistor et la borne d'alimentation négative pour établir un courant dépendant du potentiel sur l'émetteur du premier transistor; les deux branches sont montées en miroir de courant, la deuxième branche tendant à recopier le courant dans la première, ce miroir de courant comportant une sortie en courant fournissant la différence entre le courant établi dans la deuxième branche et le courant recopié de la première; un moyen est prévu pour commander la conduction du deuxième transistor à partir du courant de sortie du miroir de courant; tous les transistors bipolaires de l'étage sont des transistors NPN; la première branche comporte une première résistance en série avec un quatrième transistor; la deuxième branche comporte une deuxième résistance en série avec un cinquième transistor.

Par cette disposition, on obtient un étage entièrement NPN, et surtout un étage dont les commandes se font partout en courant et non pas en tension, de sorte qu'on est beaucoup moins limité du point de vue de la vitesse de fonctionnement : l'influence des capacités parasites n'intervient presque plus. Si on utilisait des transistors à effet de champ à grille isolée par exemple, ou tout autre système d'amplification en tension de la différence de potentiel entre les émetteurs des premier et troisième transistors, la vitesse en serait affectée défavorablement.

De préférence, les deux branches de circulation de courant comportent chacune une résistance en série avec un transistor NPN dont l'émetteur est relié à la borne d'alimentation négative. Le collecteur de ce transistor, dans le cas de la première branche, est relié à sa base, soit directement, soit par la jonction base-émetteur d'un transistor supplémentaire. Ce transistor supplémentaire sera prévu en général lorsqu'un transistor amplificateur est intercalé entre la sortie en courant du miroir de courant et la base du deuxième transistor NPN.

D'autres caractéristiques et avantages de l'invention apparaîtront à la lecture de la description détaillée qui suit et qui est faite en référence aux dessins annexés dans lesquels :
- les figures 1 et 2, déjà décrites, représentent des étages push-pull de l'art antérieur,
- la figure 3 représente un schéma préféré d'étage push-pull selon l'invention.

Sur la figure 3 on a désigné par Q1 et Q2 les deux transistors NPN principaux de l'étage selon l'invention, c'est-à-dire le transistor Q1 fournissant le courant à la charge Z (alternances positives) et le transistor Q2 absorbant le courant issu de la charge (alternances négatives). Le transistor Q1 a son collecteur relié à une borne d'alimentation positive A. Le transistor Q2 a son émetteur relié à une borne d'alimentation négative B. L'émetteur de Q1 et le collecteur de Q2 sont reliés à une sortie S. Une charge Z est reliée entre la sortie S et une masse M à un potentiel intermédiaire entre les potentiels des bornes d'alimentation A et B.

L'étage comporte un troisième transistor NPN Q3 qui a sa base reliée à la base du transistor Q1 et reliée également à l'entrée E de l'étage, et qui a son collecteur relié comme celui de Q1 à la borne positive A.

L'étage comporte encore deux branches de circulation de courant avec un système de miroir de courant.

La première branche est connectée entre l'émetteur du transistor Q3 et la borne négative B. Elle comprend principalement une résistance R1 et un transistor Q4, et accessoirement un transistor supplémentaire Q6. Dans cette branche circule un courant qui est dicté par la valeur du potentiel d'émetteur du transistor Q3, comme on l'expliquera par la suite. La résistance R1 est reliée d'un côté à l'émetteur de Q3, de l'autre à un noeud S1 auquel est raccordé le collecteur de Q4; l'émetteur de Q4 est relié à la borne d'alimentation négative B.

La deuxième branche est connectée entre l'émetteur du transistor Q1 et la borne d'alimentation négative B. Elle comprend essentiellement une résistance R2 et un transistor Q5. La résistance R2 est reliée d'un côté à l'émetteur de Q1 et de l'autre à un noeud S2 relié également au collecteur de Q5. L'émetteur de Q5 est relié à la borne B. Dans le cas le plus commode où les transistors Q4 et Q5 sont identiques, les résistances R1 et R2 sont également identiques.

Pour obtenir un montage en miroir de courant, les bases de Q4 et Q5 sont reliées entre elles, et les émetteurs de Q4 et Q5 sont également reliés. Les dimensions des transistors Q4 et Q5 sont en principe identiques; si elles ne l'étaient pas cela établirait un coefficient de recopie de courant dont il faudrait tenir compte. Par ailleurs, des petites résistances pourraient être insérées entre l'émetteur de ces transistors et la borne B, pour définir la valeur (unitaire ou non) du coefficient de recopie.

Dans le mode de réalisation de la figure 3, on a prévu un transistor Q6 dont la jonction base-émetteur est reliée entre le collecteur et la base du transistor Q4. Ce transistor est là principalement pour établir une chute de tension d'environ 0,7 volts entre le collecteur et la base de Q4, pour des raisons qu'on précisera plus loin. Une résistance R3 est reliée entre l'émetteur de Q6 et la borne d'alimentation négative B pour polariser le transistor Q6.

Le noeud S2, auquel sont reliés le collecteur de Q5 et la résistance R2, constitue une sortie du miroir de courant. Sur cette sortie est prélevé un courant qui est injecté dans la base d'un transistor Q7. Ce courant est la différence entre le courant qui circule dans la résistance R2 (imposé essentiellement en fonction du potentiel sur l'émetteur de Q1), et le courant qui circule dans le transistor Q5 (imposé par la recopie du courant dans Q4 qui lui-même est imposé essentiellement par le potentiel sur l'émetteur de Q3).

Le transistor Q7 est monté en étage suiveur de tension. Il a son émetteur relié par une résistance R4 à la borne négative B, et son collecteur relié à la borne positive A. Le transistor Q6 est de préférence identique au transistor Q7 et les résistances R3 et R4 sont alors également identiques pour qu'à l'équilibre les courants dans Q6 et Q7 soient égaux.

Enfin, la base du transistor Q2 est reliée à la sortie S3 de cet étage suiveur, c'est-à-dire à l'émetteur de Q7.

On notera que le point S3 est à un potentiel d'environ 0,7 volt (chute de tension base-émetteur de Q2) par rapport à la borne négative B; que le potentiel de S2 est à une tension de 0,7 volt au-dessus de celui de S3 (chute de tension base-émetteur de Q7); de même, le potentiel de base de Q4 et Q5 est d'environ 0,7 volt au dessus de celui de la borne B et, grâce au transistor Q6, le potentiel de la borne S1 est d'environ 1,4 volt au dessus de celui de la borne B.

Par conséquent, les potentiels de S1 et S2 sont très voisins l'un de l'autre. Si les transistors Q6 et Q7 sont de même taille et si les résistances R3 et R4 sont de même valeur, cette identité de potentiels de S1 et S2 est encore mieux respectée. Si les transistors Q6 et Q7 sont de taille différentes, les résistances R3 et R4 seront de préférence dans le même rapport que les tailles des transistors.

Le fonctionnement de l'étage est le suivant : lors des alternances positives du potentiel Ve appliqué à l'entrée E, le transistor Q1 subit directement sur sa base les augmentations du potentiel d'entrée Ve. Le potentiel Vs de la sortie S tend à suivre ces variations, avec un décalage de tension d'environ 0,7 volt : Vs = Ve-0,7 volt. Q1 fournit le courant à la charge Z. Q2 est bloqué. Simultanément, le transistor Q3 fournit sur son émetteur une tension qui est très voisine de la tension sur la sortie S puisque elle est aussi à environ 0,7 volt en dessous de la tension d'entrée sur E (chute de tension base-émetteur de Q3 d'environ 0,7 volt).

Lors des alternances négatives la tension d'émetteur de Q1 suit en principe la diminution de la tension d'entrée Ve, avec ce même décalage d'environ 0,7 volt. Mais si Ve descend trop rapidement ou si la charge est capacitive et tend à enpêcher les variations de Vs, le transistor Q1 risque de se bloquer et le potentiel de sortie ne suivra plus linéairement le potentiel d'entrée. On va montrer comment l'invention évite ce problème.

La tension Vr1 aux bornes de R1 est d'environ Ve - 3x0,7 volts. Il s'établit donc dans le transistor Q4 un courant sensiblement proportionnel à cette valeur Vr1. Ce courant est recopié dans Q5.

Parallèlement, la tension Vr2 aux bornes de R2 est sensiblement égale à Vs-2x0,7 volt, c'est-à-dire normalement Ve-3x0,7 volts. Il s'établit donc dans R2 un courant proportionnel à cette valeur, donc en principe identique au courant recopié par Q5. Mais si Vs ne reste pas égale à Ve-0,7 volt, une différence de valeur va apparaître entre le courant recopié par Q5 et le courant engendré dans R2. Cette différence de courant est absorbée dans la base du transistor Q7. Autrement dit, l'étage miroir de courant possède une sortie en courant sur S2, représentant les écarts de courant entre les deux branches, et cette sortie en courant est directement appliquée comme courant à amplifier par le transistor Q7.

Le transistor Q7 amplifie fortement ces variations de courant. La tension prélevée sur la sortie S3 sert alors directement de tension de commande base-émetteur du transistor Q2. Celui-ci peut alors très rapidement être rendu plus conducteur pour tirer un courant de la charge Z, rétablissant ainsi la tension de sortie Vs à une valeur égale à Ve-0,7 volt. Il faut remarquer qu'un très petit déséquilibre de courant dans le miroir de courant va produire une variation importante de tension aux bornes de la résistance R4 donc une variation de courant très forte dans Q2 pour évacuer le courant en provenance de la charge.

On s'arrange pour que la polarisation du transistor Q6 corresponde à la polarisation du transistor Q7, c'est-à-dire qu'en l'absence de déséquilibre le courant de base de Q6 soit égal au courant de base de Q7.

Le choix de la valeur de R4 permet d'ajuster le courant de repos traversant les transistors Q1 et Q2 en présence d'une tension d'entrée Ve nulle.

On pourrait modifier le schéma de la figure 3 soit en le simplifiant soit en le rendant plus complexe. Dans le cas de la figure 3, on utilise un transistor intermédiaire Q7 pour amplifier le courant de déséquilibre du miroir de courant; et il faut alors un transistor Q6 pour symétriser le miroir de courant. On pourrait envisager la suppression des transistors Q7 (et donc Q6) en raccordant directement la base de Q2 à la sortie S2. On pourrait également envisager des étages intermédiaires plus complexes entre S2 et la base de Q2.

L'invention permet d'obtenir un étage de sortie push-pull entièrement réalisé en transistors NPN, ayant un gain en tension inférieur ou égal à 1, ce qui est un gage de stabilité lorsqu'il est utilisé dans un circuit bouclé. L'impédance de sortie est faible. Du fait de l'utilisation de transistors NPN et d'une contre réaction par le miroir de courant, la bande passante est élevée (elle dépend essentiellement de la fréquence de coupure des transistors Q2 et Q7). La consommation de courant au repos peut être faible ou nulle, même si l'étage de sortie est construit avec des transistors Q1 et Q2 permettant une fourniture de courant élevée. La linéarité de l'étage est très bonne. Enfin, lorsque l'étage est réalisé en circuit intégré, il est moins encombrant qu'un étage qui utiliserait un transistor PNP. En effet, le transistor NPN Q2 , bien qu'il soit de taille importante, est beaucoup plus petit qu'un transistor PNP capable de délivrer le même courant; et d'autre part les transistors et résistances du miroir de courant peuvent être très petits.

## Revendications

1. Etage de sortie de type push-pull comportant, en série entre une borne d'alimentation positive (A) et une borne d'alimentation négative (B), un premier transistor de sortie NPN (Q1) pour fournir un courant à une charge (Z) et un deuxième transistor de sortie NPN (Q2) pour recevoir un courant issu de la charge, l'émetteur du premier transistor et le collecteur du deuxième étant reliés à un même noeud (S) constituant la sortie de l'étage, l'étage comportant encore un troisième transistor NPN (Q3) ayant sa base reliée à la base du premier transistor et reliée à une entrée (E) de l'étage, une première branche de circulation de courant (R1, Q4) connectée entre l'émetteur du troisième transistor et la borne d'alimentation négative (B) pour établir un courant dépendant du potentiel sur l'émetteur du troisième transistor, et une deuxième branche de circulation de courant (R2, Q5), reliée entre l'émetteur du premier transistor et la borne d'alimentation négative pour établir un courant dépendant du potentiel sur l'émetteur du premier transistor, les deux branches étant montées en miroir de courant, la deuxième branche tendant à recopier le courant dans la première, ce miroir de courant comportant une sortie en courant (S2) fournissant la différence entre le courant établi dans la deuxième branche et le courant recopié de la première, et un moyen (Q7) étant prévu pour commander la conduction du deuxième transistor à partir du courant de sortie du miroir de courant,
l'étage étant caractérisé en ce que tous les transistors bipolaires qu'il comporte sont des transistors NPN, en ce que la première branche comporte un ensemble en série d'une première résistance (R1) et d'un quatrième transistor (Q4) et la deuxième comprend un ensemble en série d'une deuxième résistance (R2) et d'un cinquième transistor (Q5).

2. Etage push-pull selon la revendication 1, caractérisé en ce que les émetteurs des quatrième et cinquième transistors sont reliés à la borne d'alimentation négative.

3. Etage push-pull selon la revendication 2, caractérisé en ce que le collecteur du transistor (Q4) de la première branche, est relié à sa base.

4. Etage push-pull selon la revendication 2, caractérisé en ce que le moyen pour commander le deuxième transistor est un transistor (Q7) monté en suiveur de tension et intercalé entre la sortie du miroir de courant et la base du deuxième transistor, et en ce qu'un transistor supplémentaire (Q6) est monté dans la première branche du miroir de courant, avec sa jonction base-émetteur entre le collecteur et la base du transistor de la première branche.

## Patentansprüche

1. Push-Pull-Ausgangsstufe, die in Reihe zwischen einer positiven Speisespannungsklemme (A) und einer negativen Speisespannungsklemme (B) einen ersten Ausgangstransistor (Q1) vom Typ NPN, der einen Strom an eine Last (Z) liefert, und einen zweiten Ausgangstransistor (Q2) vom Typ NPN aufweist, der einen von der Last kommenden Strom empfängt, wobei der Emitter des ersten Transistors und der Kollektor des zweiten Transistors an einen gemeinsamen, den Ausgang der Stufe bildenden Knoten (S) angeschlossen sind und wobei die Stufe weiter einen dritten Transistor (Q3) vom NPN-Typ besitzt, dessen Basiselektrode an die Basiselektrode des ersten Transistors sowie an einen Eingang (E) der Stufe angeschlossen ist, wobei ein erster Stromzweig (R1, Q4) zwischen den Emitter des dritten Transistors und die negative Speisespannungsklemme (B) eingefügt ist, um einen vom Potential am Emitter des dritten Transistors abhängigen Strom zu liefern, und ein zweiter Stromzweig (R2, Q5), der zwischen den Emitter des ersten Transistors und die negative Speisespannungsklemme eingefügt ist, um einen vom Potential am Emitter des ersten Transistors abhängigen Strom zu erzeugen, wobei beiden Zweige als Stromspiegel geschaltet sind und der zweite Zweig den Strom im ersten nachzubilden versucht, wobei der Stromspiegel einen Stromausgang (S2) besitzt, der den Unterschied zwischen dem im zweiten Zweig erzeugten Strom und dem im ersten Zweig nachgebildeten Strom liefert, und wobei ein Mittel (Q7) vorgesehen ist, um den zweiten Transistor aufgrund des Ausgangsstroms des Stromspiegels leitend zu steuern, dadurch gekennzeichnet, daß alle bipolaren Transistoren der Stufe NPN-Transistoren sind, daß der erste Zweig eine Serienschaltung eines ersten Widerstands (R1) und eines vierten Transistors (Q4) und der zweite Zweig eine Serienschaltung eines zweiten Widerstands (R2) und eines fünften Transistors (Q5) enthält.

2. Push-Pull-Stufe nach Anspruch 1, dadurch gekennzeichnet, daß die Emitter des vierten und des fünften Transistors an die negative Speisespannungsklemme angeschlossen sind.

3. Push-Pull-Stufe nach Anspruch 1, dadurch gekennzeichnet, daß der Kollektor des Transistors (Q4) des ersten Zweigs an seine Basiselektrode angeschlossen ist.

4. Push-Pull-Stufe nach Anspruch 1, dadurch gekennzeichnet, daß das Mittel zur Steuerung des zweiten Transistors ein Transistor (Q7) ist, der als Spannungsfolger geschaltet ist und zwischen dem Ausgang des Stromspiegels und der Basis des zweiten Transistors liegt, und daß ein zusätzlicher Transistor (Q6) im ersten Zweig des Stromspiegels derart liegt, daß sein Basis-Emitter-Übergang zwischen den Kollektor und die Basiselektrode des Transistors des ersten Zweigs eingefügt ist.

## Claims

1. Output stage of push-pull type including, in series between a positive supply terminal (A) and a negative supply terminal (B), a first NPN output transistor (Q1) for supplying a current to a load (Z) and a second (NPN) output transistor (Q2) for receiving a current originating from the load, the emitter of the first transistor and the collector of the second being linked to one and the same node (S) constituting the output of the stage, the stage further including a third NPN transistor (Q3) having its base connected to the base of the first transistor and connected to an input (E) of the stage, a first current-circulation branch (R1, Q4) connected between the emitter of the third transistor and the negative supply terminal (B) in order to establish a current dependent upon the potential on the emitter of the third transistor, and a third current-circulation branch (R2, Q5) linked between the emitter of the first transistor and the negative supply terminal in order to establish a current dependent upon the potential on the emitter of the first transistor, the two branches being mounted as a current mirror, the second branch tending to copy the current in the first, this current mirror including a current output (S2) supplying the difference between the current established in the second branch and the current copied from the first, and a means (Q7) being provided for making the second transistor conduct on the basis of the output current of the current mirror,
the stage being characterized in that all the bipolar transistors which it includes are NPN transistors, in that the first branch includes an assembly, in series, of a first resistor (R1) and of a fourth transistor (Q4), and the second comprises an assembly, in series, of a second resistor (R2) and of a fifth transistor (Q5).

2. Push-pull stage according to Claim 1, characterized in that the emitters of the fourth and fifth transistors are linked to the negative supply terminal.

3. Push-pull stage according to Claim 2, characterized in that the collector of the transistor (Q4) of the first branch is linked to its base.

4. Push-pull stage according to Claim 2, characterized in that the means for controlling the second transistor is a transistor (Q7) mounted as a voltage follower and interposed between the output of the current mirror and the base of the second transistor, and in that an additional transistor (Q6) is mounted in the first branch of the current mirror, with its base-emitter junction between the collector and the base of the transistor of the first branch.
